# EUROPÄISCHE PATENTSCHRIFT

(11) **EP 3 685 472 B1**
(45) Veröffentlichungstag und Bekanntmachung des Hinweises auf die Patenterteilung: **09.03.2022**
(21) Anmeldenummer: 18800548.2
(22) Anmeldetag: 31.10.2018
(51) Int. Cl.: H05K 7/14, H01R 4/30, H01R 11/12, H01R 31/06

(54) **SCHALTSCHRANK MIT STROMRICHTER MIT KABELANSCHLUSSELEMENTEN**
ELECTRICAL CABINET WITH POWER CONVERTER WITH CABLE CONNECTION ELEMENTS
ARMOIRE DE DISTRIBUTION AVEC CONVERTISSEUR DE PUISSANCE AVEC ÉLÉMENTS DE RACCORDEMENT DE CÂBLE

(30) Priorität: 27.11.2017 EP 17203778
(43) Veröffentlichungstag der Anmeldung: 29.07.2020
(73) Patentinhaber: Siemens Aktiengesellschaft, 80333 München (DE)
(72) Erfinder: MÜLLER, Volker, 90408 Nürnberg (DE)
(86) Internationale Anmeldenummer: PCT/EP2018/079832
(87) Internationale Veröffentlichungsnummer: WO 2019/101485

(56) Entgegenhaltungen:
- DE-A1-102010 011 383
- US-A1- 2013 273 771
- US-A1- 2014 192 455

## Beschreibung

Schaltschrank mit Stromrichter mit mindestens drei Kabelanschlusselementen.

Die Erfindung betrifft einen Schaltschrank mit einem Stromrichter mit mindestens drei Kabelanschlusselementen, wobei das Kabelanschlusselement eine elektrische Kontaktfläche und eine Montagefläche aufweist, wobei die elektrische Kontaktfläche mit einem Kabelschuh kontaktierbar ist, wobei das Kabelanschlusselement an der Montagefläche an einem Körper befestigbar ist, wobei das Kabelanschlusselement an der Montagefläche mit dem Körper des Stromrichters verbunden ist.

Elektrische Komponenten werden zum Austausch mit elektrischer Energie zumeist mit Kabeln über Anschlusselemente, auch als Kabelanschlusselement oder Anschlüsse bezeichnet, kontaktiert. Dabei kann das Kabelanschlusselement beispielsweise zur Aufnahme eines Kabelschuhs ausgebildet sein oder alternativ als Anschlussschiene oder Stromschiene beispielsweise zur Aufnahme mehrerer Kabelschuhe. Ein Beispiel für eine elektrische Komponente ist ein Stromrichter. Bei größeren Komponenten, die in einem Schaltschrank angeordnet sind, wie beispielsweise Stromrichtern erfolgt der Kabelzugang oftmals entweder von unten (typischerweise durch den Schrankboden) oder von oben (typischerweise durch das Schrankdach). Die Kabel haben an ihren Enden Kabelschuhe, welche an den Anschlüssen mittels Schrauben flach angeschraubt werden. Je größer die Leistung der elektrischen Komponente ist, desto dicker und unflexibler sind die Kabel. Gerade bei mehreren Kabeln, wie beispielsweise bei einer Energieversorgung aus einem dreiphasigen Drehstromnetz, müssen die Kabel während der Montage gebogen werden, was zum einen die Montage erschwert als auch aufgrund minimaler Biegeradien einen großen Platzbedarf im erfordert. US 2014/192455 A1 offenbart einen Schaltschrank nach dem Oberbegriff von Anspruch 1.

Der Erfindung liegt die Aufgabe zugrunde, ein Kabelanschlusselement in einem Schrank mit einem Stromrichter zu verbessern.

Diese Aufgabe wird durch einen Schaltschrank mit den Merkmalen des Anspruchs 1 gelöst.

Vorteilhafte Ausgestaltungen der Erfindung sind in den abhängigen Ansprüchen angegeben.

Der Erfindung liegt die Erkenntnis zugrunde, dass durch die geneigte Lage der elektrischen Kontaktfläche gegenüber der Montagefläche deutlich weniger Raum für die Biegung des oder der Kabel benötigt wird und/oder die Biegung des oder der Kabel deutlich geringer ausfallen kann. Dabei kann die elektrische Kontaktfläche zur Verbindung mit einem Kabelschuh oder, beispielsweise als Anschlussschiene, zur Aufnahme von einer Vielzahl von Kabelschuhen ausgebildet sein. Während bei den standardmäßig vorkommenden geraden Kabelanschlusselementen ohne Neigung mehrfache Biegungen, beispielsweise in einem S-förmiger Verlauf, des Kabels entstehen, passt sich durch die geneigte Lage der elektrischen Kontaktfläche der Kabelverlauf in einem stärkeren Maß an den natürlichen Verlauf des Kabels an. Dadurch werden Biegungen in Anzahl und Ausmaß im Kabel reduziert. Durch die reduzierte Anzahl der Biegungen im Kabel werden darüber hinaus die mechanischen Spannungen im Kabel reduziert. Dies senkt die auf das Kabelanschlusselement übertragenen Kräfte, so dass der Anschluss einfacher, insbesondere kleiner und kostengünstiger, ausgeführt werden kann.

Besonders vorteilhaft ist die Möglichkeit, mit geraden Standardkabelschuhen einen deutlich kompakteren Kabelanschlussraum zu realisieren und dabei gleichzeitig die am Kabelanschluss auftretenden Kräfte zu reduzieren. Auch kann durch Variation des Anstellwinkels der für die Anwendung optimale Anstellwinkel genutzt werden.

Gegenüber einer am Markt befindlichen alternativen Lösung mit der Verwendung von Kabelschuhen mit schräger Anschlusslasche ist es bei dem erfindungsgemäßen Anschlusselement möglich, Standardkabelschuhe zu verwenden. Gerade bei unterschiedlichen Anstellwinkeln bei verschiedenen Kabelanschlusselementen an einer elektrischen Komponente ist die Verwendung gleichartiger Kabelschuhe gerade im Hinblick auf die Verwendung von Gleichteilen besonders vorteilhaft. Dies ermöglicht es, die gleichen Vorteile zu erreichen. Ebenso können auf einfache Weise auch spezielle Kabelendverschlüssen verwendet werden, die nur in geringen Ausprägungen am Markt verfügbar sind.

Der Stromrichter dient dabei als Körper, an dem das Kabelanschlusselement befestigt wird. Die Befestigung kann beispielsweise an der Oberfläche des Stromrichters geschehen. Gerade in einem Schaltschrank sind die Platzverhältnisse zumeist sehr beschränkt, so dass nur wenig Raum für die Führung der Kabel verbleibt, der mit dem Kabelanschlusselement bestmöglich ausgenutzt wird.

Mittels des Kabelanschlusselementes wird elektrische Energie zwischen einem Kabel und Komponenten im Innern des Stromrichters übertragen. Bei den Komponenten im Innern des Stromrichters kann es sich um Halbleiterbauelemente handeln, mit denen eine elektrische Verbindung hergestellt wird.

Das Kabelanschlusselement kann einteilig ausgeführt sein und dabei zwischen der Ebene der elektrischen Kontaktfläche und der Ebene der Montagefläche einen Winkel α aufweisen. Alternativ ist es auch möglich, dass das Kabelanschlusselement mehrteilig, insbesondere zweiteilig ausgeführt ist. Dabei dient ein erster leitender Teil zur Verbindung mit dem Kabel, während ein zweiter Teil, beispielsweise als Adapter, zur Befestigung am Körper dient. Bei dem Körper kann es sich beispielsweise um ein Gehäuse oder einer weiteren Montagefläche des Stromrichters handeln. Dabei kann der Adapter derart ausgebildet sein, dass nach dem Zusammenfügen der beiden Teile des Kabelanschlusselements die Ebene der elektrischen Kontaktfläche und die Ebene der Montagefläche sich schneiden.

Dabei weist der Stromrichter mindestens drei Kabelanschlusselemente auf. Drei Kabel sind für einen Anschluss an ein dreiphasiges Drehstromnetz erforderlich. Gerade elektrische Komponenten mit großer Leistung, beispielsweise oberhalb 100kW, werden häufig aus einem Drehstromnetz mit elektrischer Energie versorgt. Gleichzeitig sind aufgrund der hohen Leistung derart große Kabelquerschnitte erforderlich, welche die Biegsamkeit der Kabel herabsetzt. Teilweise sind darüber hinaus Mindestradien bei der Biegung der Kabel einzuhalten. Bei der Verwendung von elektrischen Kontaktflächen, die parallel zur Oberfläche des Gehäuses ausgerichtet sind, ist ein großer Abstand zwischen den einzelnen Kabelanschlusselementen vorzusehen, damit die Kabelwege der einzelnen Kabel sich nicht gegenseitig behindern. Durch die geneigte Lage der elektrischen Kontaktfläche können die Kabelanschlusselemente deutlich näher zueinander angeordnet werden, da die Kabel nicht gebogen werden müssen, um die anderen übrigen Anschlusselemente nicht zu verdecken. Dadurch kann ein besonders räumlich kompakter Anschluss der Kabel an die elektrische Komponente erfolgen, ohne starke Biegungen im Kabel vorsehen zu müssen. Gleichzeitig sind die auftretenden mechanischen Kräfte relativ gering. Somit ist es beispielsweise möglich, die einzelnen Kabelanschlusselemente in einem Abstand zwischen 5cm und 20cm beabstandet zueinander anzuordnen.

Dabei hat es sich als besonders vorteilhaft erwiesen, wenn der Anstellwinkel der unterschiedlichen Kabelanschlusselemente sich unterscheidet. Damit können auf einfache Weise die unterschiedlichen Kabelverläufe der einzelnen Kabel mit geringen Biegungen realisiert werden.

Bei einer vorteilhaften Ausgestaltung der Erfindung schneiden sich die Ebene der elektrischen Kontaktfläche und die Ebene der Montagefläche in einem Winkel im Bereich zwischen 5° und 45°. Dieser Winkel wird auch als Anstellwinkel bezeichnet. Um die Biegung des Kabels möglichst gering zu halten, haben sich ein geneigtes Anschlusselement bzw. eine geneigte Anschlussschiene mit einem Anstellwinkel in dem genannten Bereich als besonders vorteilhaft bei der Kabelführung erwiesen. Damit kann eine Kabelführung in der Nähe der elektrischen Komponente vermieden werden und ein hinreichender Abstand zwischen Kabel und elektrischer Komponente sichergestellt werden.

Bei einer weiteren vorteilhaften Ausgestaltung der Erfindung schneiden sich die Ebene der elektrischen Kontaktfläche und die Ebene der sich in der Umgebung der elektrischen Kontaktfläche befindlichen Oberfläche der elektrischen Komponente, insbesondere schneiden sie sich in einem weiteren Winkel im Bereich zwischen 5° und 45°. Die Vorteile des Kabelanschlusselementes kommen insbesondere dann zur Geltung, wenn die elektrische Kontaktfläche gegenüber der Oberfläche des Gehäuses der elektrischen Komponenten, die sich in unmittelbarer Umgebung des Kabelanschlusselementes befindet, geneigt ist. Dies ist insbesondere dann der Fall, wenn die elektrische Komponente oder die elektrischen Komponenten in räumlich stark eingeschränkter Umgebung angeordnet werden, wie es beispielsweise in einem Schaltschrank der Fall ist. Damit lässt sich eine besonders platzsparende Anordnung erzielen, da sich auf einfache Weise unterschiedliche Kabelverläufe der einzelnen Kabel mit nur geringen Biegungen der Kabel realisieren lassen.

Erfindungsgemäß sind zumindest zwei der Kabelanschlusselemente im Schaltschrank übereinander angeordnet, wobei Kabel, die über den Kabelschuh mit den jeweiligen Kabelanschlusselementen verbunden sind, über den Boden oder das Dach des Schaltschrankes aus dem Schaltschrank herausgeführt werden. Durch die Anordnung übereinander werden die Kabel in unmittelbarer Nähe zueinander geführt und kommen sich dadurch in die Quere. Dieser Effekt kann dadurch besonders vorteilhaft abgewendet werden, dass die Kabelanschlusselemente erfindungsgemäß einen Anstellwinkel aufweisen. Dieser stellt dann nicht nur sicher, dass die Biegungen der Kabel herabgesetzt werden, sondern auch, dass die Kabel nur einen geringen Druck aufeinander ausüben.

Bei einer weiteren vorteilhaften Ausgestaltung der Erfindung unterscheiden sich die Anstellwinkel der unterschiedlichen Kabelanschlusselemente. Durch die unterschiedlichen Anstellwinkel sind die Kabel besonders platzsparend im Schaltschrank führbar. Dies gilt insbesondere für den Fall, wenn die Kabelanschlusselemente übereinander angeordnet sind. Durch die unterschiedlichen Anstellwinkel kann dann der gegenseitige Druck der Kabel aufeinander weiter reduziert werden.

Im Folgenden wird die Erfindung anhand der in den Figuren dargestellten Ausführungsbeispiele näher beschrieben und erläutert. Es zeigen:
- FIG 1: einen Anschluss aus dem Stand der Technik
- FIG 2: ein Kabelanschlusselement,
- FIG 3, FIG 4: Ausführungsbeispiele für ein Kabelanschlusselement mit geneigter elektrischer Kontaktfläche und
- FIG 5: einen Stromrichter mit geneigten Kabelanschlusselementen.

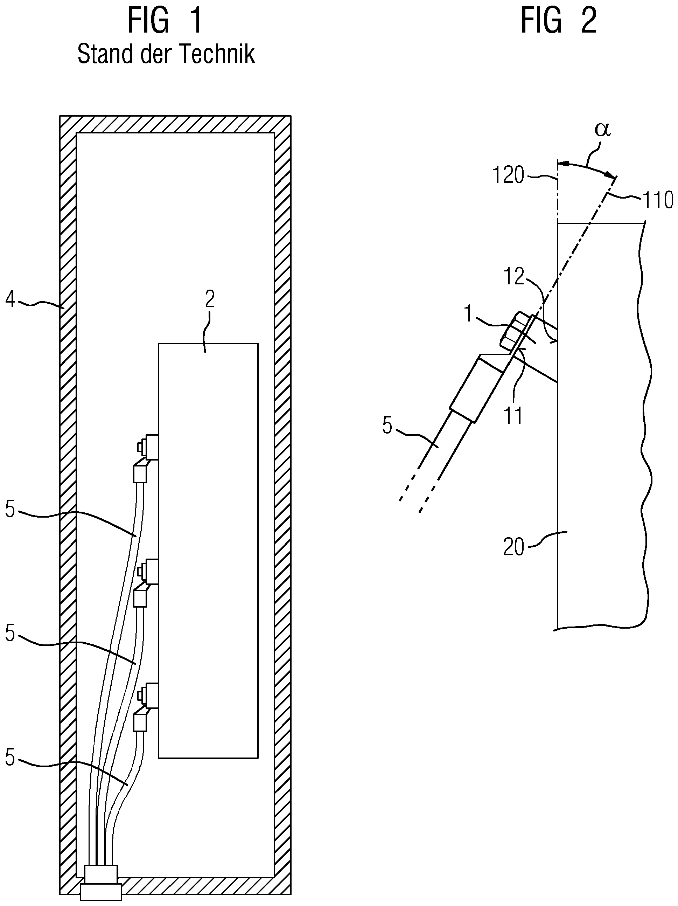

Die FIG 1 zeigt eine aus dem Stand der Technik bekannte Anordnung mit einem Schaltschrank 4, in dem eine elektrische Komponente 2 angeordnet ist. Diese elektrische Komponente 2 wird über drei Kabel 5 mit elektrischer Energie versorgt. Die Kabel 5 sind über Anschlusselemente mit der elektrischen Komponente 2 verbunden. Die Kontaktfläche ist gegenüber der Fläche der elektrischen Komponente 2, an der die Anschlusselemente an der elektrischen Komponente 2 angebracht sind, parallel ausgerichtet. Dadurch sind die Kabel 5 S-förmig gebogen, um die Anschlusselemente der anderen Kabel 5 nicht zu verdecken und gleichzeitig durch die Durchführung im Schaltschrank 4 geführt werden zu können.

Die FIG 2 zeigt ein Kabelanschlusselement 1. An der elektrischen Kontaktfläche 11 des Kabelanschlusselementes 1 ist das Kabel 5 beispielsweise mittels eines Kabelschuhs und einer Schraube befestigt. Das Kabelanschlusselement 1 ist an der Montagefläche 12 mechanisch mit einem Körper 20 verbunden. Dabei ist die Ebene 110 der elektrischen Kontaktfläche 11 zur Ebene 120 der Montagefläche 12 geneigt. Das heißt, die Ebene 110 der elektrischen Kontaktfläche 11 und die Ebene 120 der Montagefläche 12 schneiden sich in einem Winkel α. Dieser Winkel α wird auch als Anstellwinkel bezeichnet.

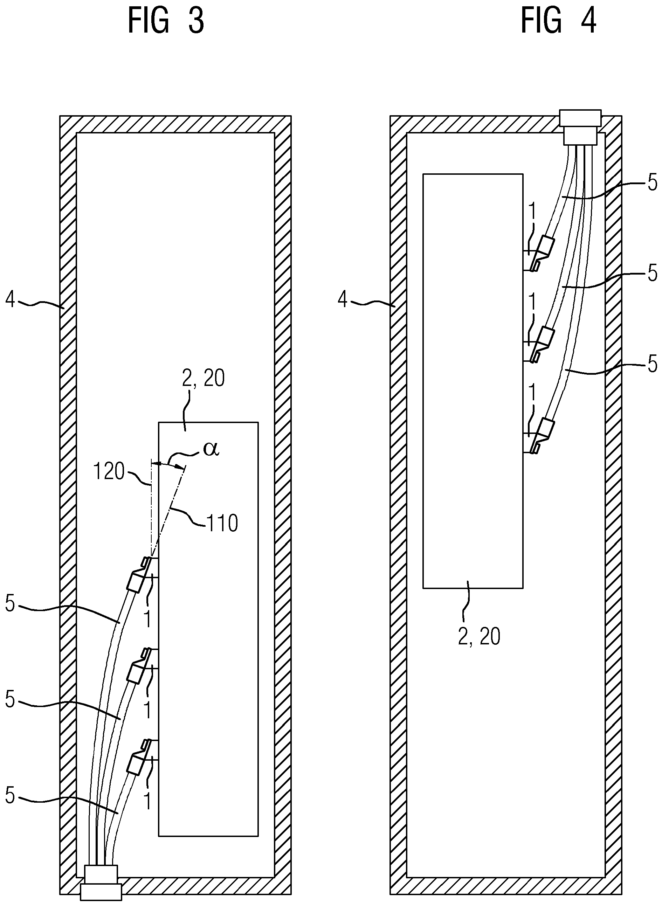

Die FIG 3 zeigt ein Ausführungsbeispiel eines Schaltschrankes 4, in dem eine elektrische Komponente 2 angeordnet ist. Dabei wird auch hier die elektrische Komponente 2 über drei Kabel 5 mit elektrischer Energie versorgt. Jedoch erfolgt die elektrische Verbindung mit der elektrischen Komponente 2 mittels jeweils eines Kabelanschlusselements 1 nach FIG 2. Dabei stellt der Körper 20 in diesem Ausführungsbeispiel die elektrische Komponente 2 dar. Das Kabelanschlusselement 1 weist dabei die elektrische Kontaktfläche 11 zur Verbindung mit dem Kabel 5 auf, die gegenüber der Montagefläche 12, an der das Kabelanschlusselement 1 mit der elektrischen Komponente 2 befestigt ist, geneigt ist. Durch diese Neigung um den Winkel α können die Kabel 5 mit weniger Biegungen auf dem Weg von der Kabeldurchführung des Schaltschrankes 4 zu dem Kabelanschlusselement 1 geführt werden. Ebenso reduzieren sich damit die vom Kabel 5 auf das Kabelanschlusselement 1 übertragenen mechanischen Kräfte. Dabei kann die Kabeldurchführung am Boden des Schaltschrankes 4 angeordnet sein, wie in FIG 3 dargestellt, oder entsprechend FIG 4 am Dach des Schaltschrankes 4. Bezüglich der FIG 4 wird auf die Beschreibung zur FIG 3 sowie auf die dort eingeführten Bezugszeichen verwiesen.

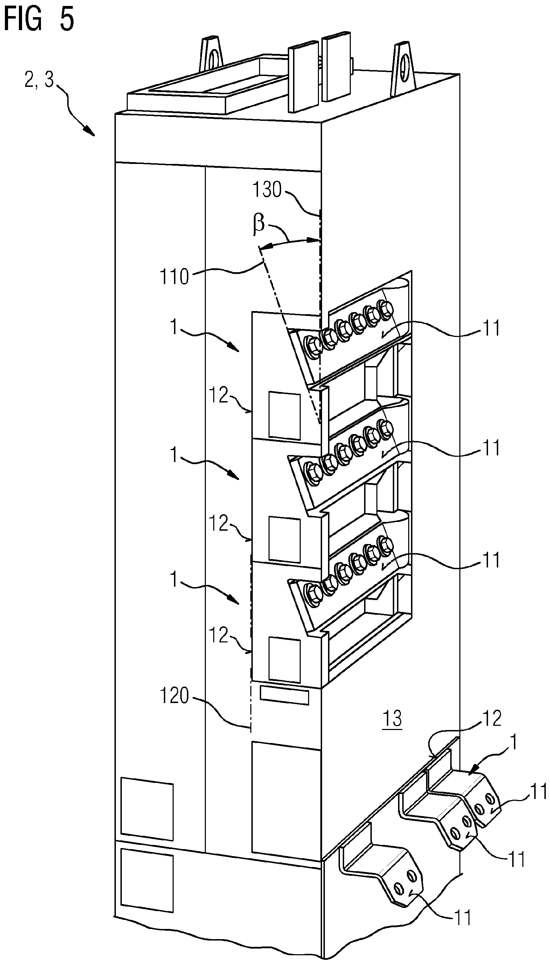

Die FIG 5 zeigt einen Stromrichter 3 als elektrische Komponente 2. Die elektrischen Anschlüsse sind als Kabelanschlusselemente 1 ausgeführt, bei der die elektrische Kontaktfläche 11 gegenüber der Montagefläche 12 geneigt ist. Dabei ist die Ebene 120 der Montagefläche 12 gegenüber der Ebene 130 in der Umgebung der elektrischen Kontaktfläche 11 befindlichen Oberfläche der elektrischen Komponente 2 zueinander versetzt angeordnet. Diese versetzte Anordnung kann dabei parallel versetzt angeordnet sein oder auch einen Winkel zueinander aufweisen. Die Ebene 110 der elektrischen Kontaktfläche 11 und die Ebene 130 der in der Umgebung der elektrischen Kontaktfläche 11 befindlichen Oberfläche der elektrischen Komponente 2 schneiden sich dabei in einem weiteren Winkel β. Dies ermöglicht eine besonders vorteilhafte Kabelführung, da durch diesen weiteren Winkel β auch ohne starke Biegungen der hier nicht dargestellten Kabel der Kabelverlauf auf einfache Weise in einem gewünschten Abstand zur Oberfläche, insbesondere zu der in der Umgebung der elektrischen Kontaktfläche 11 befindlichen Oberfläche, des Stromrichters 3 erfolgen kann.

## Patentansprüche

1. Schaltschrank (4) mit einem Stromrichter (3) mit mindestens drei Kabelanschlusselementen (1), wobei das jeweilige Kabelanschlusselement (1) eine elektrische Kontaktfläche (11) und eine Montagefläche (12) aufweist, wobei die elektrische Kontaktfläche (11) mit einem Kabelschuh kontaktierbar ist, wobei das Kabelanschlusselement (1) an der Montagefläche an einem Körper (20) befestigbar ist, wobei die elektrische Kontaktfläche (11) und die Montagefläche (12) derart an dem Kabelanschlusselement (1) angeordnet sind, dass die Ebene (110) der elektrischen Kontaktfläche (11) und die Ebene (120) der Montagefläche (12) sich in einem Anstellwinkel (α) schneiden, wobei das Kabelanschlusselement (1) an der Montagefläche (12) mit dem Körper (20) des Stromrichters (3) verbunden ist, wobei der Stromrichter (3) mindestens drei Kabelanschlusselemente (1) aufweist, wobei Kabel, die über den Kabelschuh mit dem jeweiligen Kabelanschlusselement (1) verbunden sind, über den Boden oder das Dach des Schaltschrankes aus dem Schaltschrank (4) herausgeführt werden, **dadurch gekennzeichnet, dass** zumindest zwei der Kabelanschlusselemente (1) im Schaltschrank (4) übereinander angeordnet sind.

2. Schaltschrank (4) nach Anspruch 1, wobei der Anstellwinkel (α) einen Wert im Bereich zwischen 5° und 45° annimmt.

3. Schaltschrank (4) nach einem der Ansprüche 1 oder 2, wobei die Anstellwinkel (α) der unterschiedlichen Kabelanschlusselemente (1) sich unterscheiden.

4. Schaltschrank (4) nach einem der Ansprüche 1 bis 3, wobei die Ebene (110) der elektrischen Kontaktfläche (11) und die Ebene (130) der sich in der Umgebung der elektrischen Kontaktfläche (11) befindlichen Oberfläche (13) des Stromrichters (3) sich schneiden, insbesondere sich in einem weiteren Winkel (β) im Bereich zwischen 5° und 45° schneiden.

## Claims

1. Switchgear cabinet (4) with a current converter (3) with at least three cable connection elements (1), wherein the respective cable connection element (1) has an electrical contact area (11) and an assembly area (12), wherein the electrical contact area (11) can be brought into contact with a cable lug, wherein the cable connection element (1) can be fastened at the assembly area to a body (20), wherein the electrical contact area (11) and the assembly area (12) are arranged on the cable connection element (1) such that the plane (110) of the electrical contact area (11) and the plane (120) of the assembly area (12) intersect in a positioning angle (α), wherein the cable connection element (1) is connected at the assembly area (12) to the body (20) of the current converter (3), wherein the current converter (3) has at least three cable connection elements (1), wherein cables connected to the respective cable connection element (1) via the cable lug are guided out of the switchgear cabinet (4) via the base or the top of the switchgear cabinet, **characterised in that** at least two of the cable connection elements (1) are arranged one above the other in the switchgear cabinet (4).

2. Switchgear cabinet (4) according to claim 1, wherein the positioning angle (α) assumes a value in the range between 5° and 45°.

3. Switchgear cabinet (4) according to one of claims 1 or 2, wherein the positioning angles (α) of the different cable connection elements (1) differ.

4. Switchgear cabinet (4) according to one of claims 1 to 3, wherein the plane (110) of the electrical contact area (11) and the plane (130) of the surface (13) of the current converter (3) situated in the surrounding area of the electrical contact area (11) intersect, in particular intersect in a further angle (β) in the range between 5° and 45°.

## Revendications

1. Armoire (4) de distribution comprenant un convertisseur (3) ayant au moins trois éléments (1) de connexion de câble, dans lequel l'élément (1) respectif de connexion de câble a une surface (11) de contact électrique et une surface (12) de montage, dans laquelle la surface (11) de contact électrique peut être mise en contact avec une cosse de câble, dans laquelle l'élément (1) de connexion de câble peut être fixé à la surface de montage à un corps (20), dans laquelle la surface (11) de contact électrique et la surface (12) de montage sont disposées sur l'élément (1) de connexion de câble, de manière à ce que le plan (110) de la surface (11) de contact électrique et le plan (120) de la surface (12) de montage se coupent suivant un angle (α) d'incidence, dans laquelle l'élément (1) de connexion de câble est relié à la surface (12) de montage au corps (20) du convertisseur (3), dans laquelle le convertisseur (3) a au moins trois éléments de connexion de câble, dans laquelle des câbles, qui sont reliés par la cosse de câble à l'élément (1) respectif de connexion de câble, sortent de l'armoire (4) de distribution par le plancher ou par le plafond de l'armoire de distribution, **caractérisée en ce qu'**au moins deux des éléments (1) de connexion de câble sont superposés dans l'armoire (4) de distribution.

2. Armoire (4) de distribution suivant la revendication 1, dans laquelle l'angle (α) d'incidence prend une valeur dans la plage comprise entre 5° et 45°.

3. Armoire (4) de distribution suivant la revendication 1 ou 2, dans laquelle les angles (α) d'incidence des éléments (1) différents de connexion de câble sont différents.

4. Armoire (4) de distribution suivant l'une des revendications 1 à 3, dans laquelle le plan (110) de la surface (11) de contact électrique et la plan (130) de la surface (13) se trouvant au voisinage de la surface (11) de contact électrique du convertisseur (3) se coupent, notamment suivant un autre angle (β) dans la plage comprise entre 5° et 45°.
